# FASCICULE DE BREVET EUROPEEN

(11) **EP 3 200 662 B1**
(45) Date de publication et mention de la délivrance du brevet: **02.06.2021**
(21) Numéro de dépôt: 15787252.4
(22) Date de dépôt: 28.09.2015
(51) Int. Cl.: A47J 36/06, A47J 37/10, A47J 45/07, H01L 35/30

(54) **POIGNÉE AMOVIBLE COMPRENANT UN GÉNÉRATEUR THERMOÉLECTRIQUE**
ABNEHMBARER GRIFF MIT EINEM THERMOELEKTRISCHEN GENERATOR
REMOVABLE HANDLE COMPRISING A THERMOELECTRIC GENERATOR

(30) Priorité: 30.09.2014 FR 1459229
(43) Date de publication de la demande: 09.08.2017
(73) Titulaire: SEB S.A., 69130 Ecully (FR)
(72) Inventeur: COMPEAU, Jean-Louis, 38070 Saint Quentin Fallavier (FR)
(74) Mandataire: SEB Développement
(86) Numéro de dépôt international: PCT/FR2015/052576
(87) Numéro de publication internationale: WO 2016/051057

(56) Documents cités:
- EP-A1- 2 361 538
- EP-A1- 2 606 791
- WO-A1-2009/147688
- WO-A1-2013/007932
- WO-A1-2013/130365
- WO-A2-2004/008923
- FR-A1- 2 977 121
- US-A- 5 620 255
- US-A1- 2007 228 056
- US-A1- 2008 290 104
- US-B1- 6 279 568

## Description

L'invention se situe dans le domaine des poignées amovibles pour des récipients de cuisson (appelés également récipients) ou pour des couvercles de récipients de cuisson, appelés simplement couvercles. L'invention concerne plus particulièrement des poignées amovibles intégrant des dispositifs de fourniture d'électricité dans le but d'alimenter des fonctions électroniques et qui fonctionnent sur le principe de la conversion thermoélectrique.

On connait déjà des récipients de cuisson, comme par exemple des poêles à frire, qui utilisent un dispositif de fourniture d'électricité, tel qu'un générateur thermoélectrique, pour alimenter un système électronique d'indication de température situé dans la poignée. Lorsque les poêles à frire sont chauffées, un flux thermique se crée. Le générateur thermoélectrique utilise ce flux thermique pour produire de l'électricité nécessaire au fonctionnement du système électronique d'indication.

Les poignées amovibles sont également connues et sont utilisées par exemple sur des récipients de cuisson ou sur des couvercles. Un des avantages apporté par les poignées amovibles réside dans la facilité de rangement des récipients de cuisson ou des couvercles lorsque la poignée amovible est retirée de ceux-ci. Un autre avantage réside dans le fait qu'une seule poignée est nécessaire pour les différents récipients de cuisson ou les différents couvercles.

Le document CN201015533 divulgue une poêle à frire qui comprend un corps de poêle ainsi qu'une poignée. La poignée est vissée au corps de poêle et elle est fixe par rapport à celui ci, c'est-à-dire qu'un utilisateur peut la retirer du corps de poêle seulement en réalisant une opération de dévissage, voire il ne peut pas la retirer du tout. La poêle à frire comprend également un capteur de température et cette température peut être visualisée sur un afficheur intégré dans la poignée. Afin d'alimenter ce capteur et cet afficheur, la poêle à frire comprend un générateur thermoélectrique qui fournit l'électricité nécessaire au fonctionnement du capteur et de l'afficheur. Pour produire de l'électricité, ce générateur thermoélectrique comprend deux faces dont la première est positionnée contre le corps de la poêle. Ce positionnement permet d'assurer un échange thermique entre le générateur thermoélectrique et le corps de la poêle. Ce document divulgue également un dissipateur thermique relié à la seconde face du générateur thermoélectrique. Le dissipateur thermique est destiné à favoriser le refroidissement du générateur thermoélectrique et il a la forme d'un radiateur métallique comprenant des ailettes qui s'élèvent verticalement. Le document EP 2 606 791 A1 montre un autre exemple de poignée pour récipient de cuisson avec générateur thermoélectrique.

Un des problèmes rencontrés avec les poignées telles que divulguées dans le document précédent est que par construction elles sont associées à un seul récipient de cuisson ou à un seul couvercle ce qui ne facilite pas le rangement des récipients de cuisson ou des couvercles. Un autre problème rencontré est qu'au cours des différentes préhensions de la poignée, un jeu mécanique peut s'installer entre le générateur thermoélectrique et le récipient de cuisson ou le couvercle ce qui a pour effet de diminuer l'échange thermique entre ces deux éléments. Dans ce cas de figure une perte de rendement au niveau du générateur thermoélectrique est observée.

L'un des aspects que se propose de résoudre la présente invention est de proposer une poignée qui puisse être amovible du récipient de cuisson ou du couvercle tout en pouvant fournir de l'électricité, de manière fiable et constante au cours du temps, à des fonctions électroniques annexes. Pour cela une des difficultés à surmonter consiste à avoir un échange thermique performant entre le générateur thermoélectrique et le récipient de cuisson ou le couvercle lorsque la poignée est verrouillée et/ou retirée au cours des utilisations successives. De ce fait on aura une seule poignée amovible pouvant disposer de fonctions électroniques alimentées en électricité de manière autosuffisante et fiable.

Ce but est atteint à l'aide d'une poignée pour récipient de cuisson ou couvercle qui comprend au moins un générateur thermoélectrique, caractérisée en ce que la poignée comprend un dispositif de verrouillage libérable et le générateur thermoélectrique comprend au moins une première surface de contact reliée thermiquement à une pièce de couplage thermique qui vient en contact sous contrainte avec une portion du récipient de cuisson ou du couvercle lorsque le dispositif de verrouillage libérable de la poignée est dans une position verrouillée sur le récipient de cuisson ou le couvercle.

Selon une caractéristique de l'invention le générateur thermoélectrique comprend une seconde surface de contact reliée thermiquement à une pièce de jonction.

Selon une caractéristique de l'invention, la poignée comprend un dissipateur thermique relié thermiquement à la pièce de jonction ou à la seconde surface de contact du générateur thermoélectrique.

Selon un premier mode de réalisation, le dissipateur thermique est composé d'une ou plusieurs ailettes de longueur inférieure à la poignée.

Selon une caractéristique de l'invention, les ailettes sont réalisées dans un matériau conducteur de chaleur.

Selon une variante, les ailettes sont des caloducs.

Selon un second mode de réalisation de la poignée, le dissipateur thermique est composé d'un radiateur comprenant au moins deux ailettes montées verticalement et parallèlement pour obtenir un refroidissement par convection.

Selon un troisième mode de réalisation de la poignée, le dissipateur thermique est un dissipateur à chaleur latente composé d'un corps solide qui comprend un point de fusion compris entre 50°C et 70°C.

Selon une caractéristique de réalisation de la poignée, celle-ci comprend un diffuseur thermique.

Selon une caractéristique de l'invention, la poignée comprend un dispositif électronique relié au générateur thermoélectrique.

Selon une caractéristique de l'invention, le dispositif électronique peut être un afficheur électronique ou un capteur électronique.

Selon une caractéristique de l'invention, la poignée comprend des ouvertures débouchantes transversales et/ou des ouvertures débouchantes longitudinales de ventilation.

Selon une caractéristique de l'invention la poignée comprend un micro-ventilateur relié au générateur thermoélectrique.

L'invention concerne également un dispositif de génération d'électricité pour poignée de récipient de cuisson ou de couvercle, le dispositif de génération d'électricité comprend un générateur thermoélectrique et le dispositif de génération d'électricité comprend une pièce de couplage thermique reliée thermiquement au générateur thermoélectrique et un dissipateur thermique relié thermiquement au générateur thermoélectrique et le dispositif de génération d'électricité est amovible de la poignée.

On comprendra mieux les buts, aspects et avantages de la présente invention, d'après la description donnée ci-après de modes particuliers de réalisation de l'invention présenté à titre d'exemple non limitatif, en se référant aux dessins annexés dans lesquels :
- la figure 1 est une vue en perspective d'un récipient de cuisson et d'une poignée dans un premier mode de réalisation ;
- la figure 2 est une vue en perspective de la poignée conforme au premier mode de réalisation ;
- la figure 3 est une vue en perspective d'une partie de la poignée conforme au premier mode de réalisation ;
- la figure 4 est une vue en perspective d'une poignée dans un deuxième mode de réalisation ;
- la figure 5 est une vue en perspective d'une poignée dans un troisième mode de réalisation ;

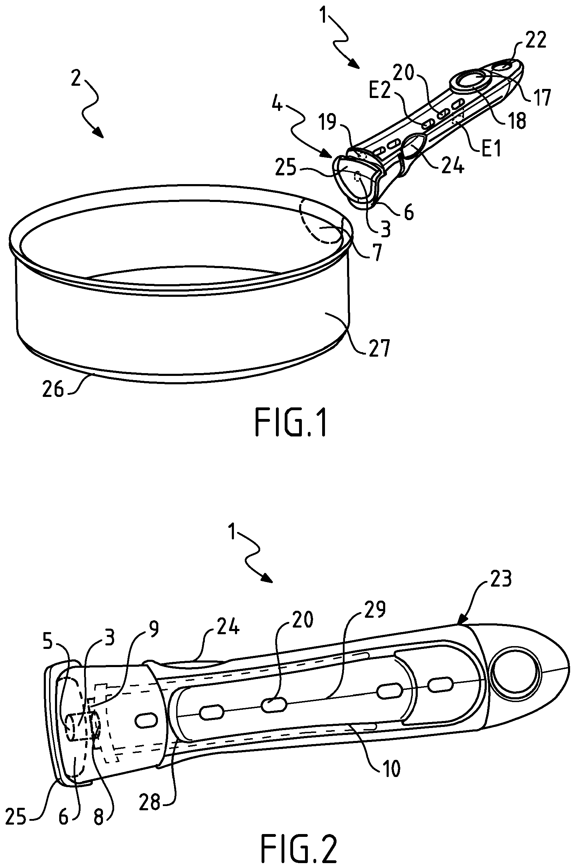

La poignée (1) pour récipient (2) de cuisson (appelé simplement récipient (2) dans la suite) ou pour des couvercles de récipients de cuisson (appelés simplement couvercles), telle qu'illustrée sur la figure 1, comprend un dispositif (4) de verrouillage libérable. Ce dispositif (4) de verrouillage libérable comprend un ou plusieurs boutons (24) d'actionnement destinés à mettre en mouvement au moins une pièce (25) de serrage. Cette pièce (25) de serrage permet de fixer la poignée (1) à un récipient (2) ou à un couvercle.

Dans le cas d'un récipient (2), celui-ci comprend un fond (26), une paroi (27) qui entoure le fond (26) et une poignée (1) qui vient s'attacher sur la paroi (27). Ce récipient (2) peut être par exemple une poêle à frire mais peut également être une casserole, un faitout ou tout autre contenant métallique destiné à être chauffé thermiquement au niveau du fond (26). Le récipient (2) peut être fait en aluminium ou tout autre matériau conducteur de chaleur.

Lorsqu'un utilisateur souhaite verrouiller la poignée (1) sur le récipient (2), la pièce (25) de serrage vient serrer une portion (7) de la paroi (27) du récipient (2) au niveau de la partie haute de cette paroi (27).

Dans un autre mode de réalisation du dispositif (4) de verrouillage libérable, le récipient (2) comprend un couvercle (non représenté) et la pièce (25) de serrage vient serrer une portion du couvercle.

Lorsque le récipient (2) est chauffé, cette portion (7) va s'échauffer. Il en est de même pour la portion du couvercle qui est serrée par la pièce (25) de serrage.

Comme visible à la figure 2, la poignée (1) comprend un corps principal (23). De façon non limitative celui-ci est fait dans un matériau thermostable. Ce corps principal (23) peut également être fait dans tout autre matériau non conducteur de chaleur.

Le corps principal (23) est évidé en son centre et dans la longueur de la poignée (1) afin d'obtenir une cavité (28). De cette manière la cavité (28) peut contenir différents éléments nécessaires au fonctionnement de l'invention comme un générateur (3) thermoélectrique, un dissipateur (10) thermique et un mécanisme (29) relatif au dispositif (4) de verrouillage libérable.

Le générateur (3) thermoélectrique contenu dans la cavité (28) est constitué d'au moins un module thermoélectrique qui peut être un module Peltier. Dans ce cas de figure, il présente deux surfaces (5, 8) de contact. Une première (5) surface de contact, dite chaude, est mise en contact avec une source de chaleur alors que la seconde (8) surface de contact, dite froide, est quant à elle mise en contact avec une source froide.

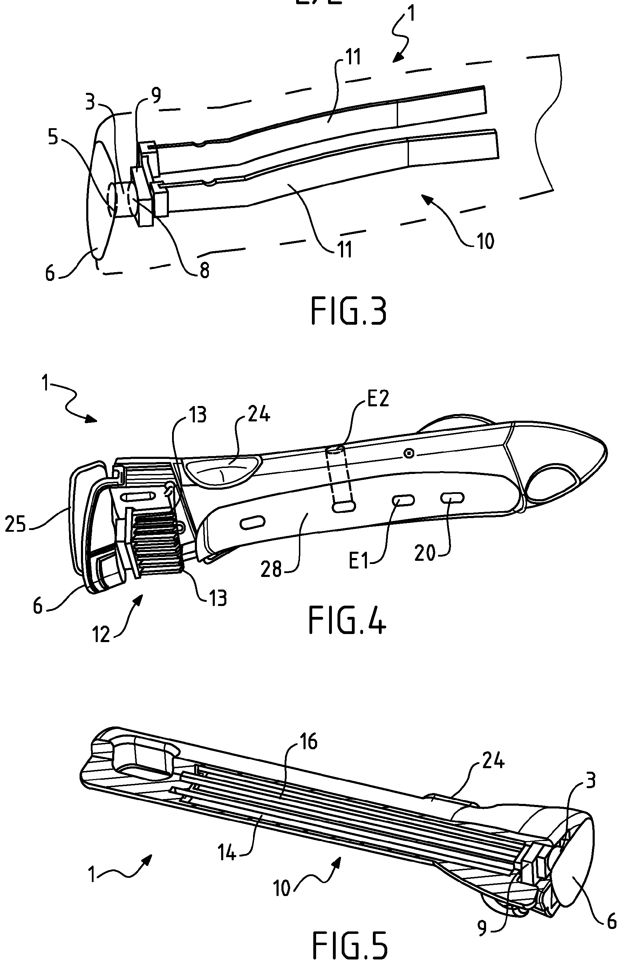

Comme cela est visible sur la figure 3, la poignée (1) peut également comprendre une pièce (9) de jonction. La seconde (8) surface de contact du générateur (3) thermoélectrique est alors reliée thermiquement à cette pièce (9) de jonction.

Par reliée thermiquement, on entend que le contact entre la seconde (8) surface de contact et la pièce (9) de jonction a une résistance thermique minimale.

Toutefois la pièce (9) de jonction n'est pas indispensable et dans une autre variante, la poignée (1) ne comprend pas de pièce (9) de jonction comme cela sera décrit par la suite.

Comme visible sur les figures 1 et 3, la poignée (1) comprend également une pièce de couplage (6) thermique, dénommée pièce de couplage (6). Cette pièce de couplage (6) est reliée thermiquement à la première (5) surface de contact du générateur (3) thermoélectrique. Cette pièce de couplage (6) est prévue pour venir en contact avec la portion (7) du récipient (2) lorsque la poignée (1) est dans une position verrouillée c'est-à-dire lorsque la pièce (25) de serrage vient fixer la poignée (1) au récipient (2) ou au couvercle. Cette pièce de couplage (6) est située sensiblement en vis-à-vis de la pièce (25) de serrage et de l'autre côté de la portion (7) par rapport à la pièce (25) de serrage lorsque la poignée est positionnée sur le récipient (2) ou le couvercle. Le fonctionnement et l'utilité de cette pièce de couplage (6) seront détaillés par la suite. Une fois la poignée (1) verrouillée sur la paroi (27), la pièce de couplage (6) est alors en contact sous contrainte avec la portion (7) de la paroi (27).

De manière préférentielle cette pièce de couplage (6) est métallique et est faite soit en aluminium, soit en cuivre.

La poignée (1) comprend également un dissipateur (10) thermique visible à la figure 3. Dans le premier mode de réalisation de la poignée (1), visible à la figure 3, ce dissipateur (10) thermique est contenu dans la cavité (28) de la poignée (1) et il n'interfère pas avec le mécanisme (29) relatif au dispositif (4) de verrouillage libérable également contenu dans la cavité (28) de la poignée (1). Le dissipateur (10) thermique est relié thermiquement à la pièce (9) de jonction.

Dans une variante de réalisation, il n'y a pas de pièce (9) de jonction et le dissipateur (10) thermique est relié directement à la seconde (8) surface de contact du générateur (3) thermoélectrique.

Toujours dans le premier mode de réalisation de la poignée, le dissipateur (10) thermique est composé de deux ailettes (11) contenues dans la cavité (28) de la poignée (1). Elles sont orientées le long de la poignée (1) dans le sens longitudinal.

Ces ailettes (11) sont parallèles et ont une longueur inférieure à celle de la poignée (1) Et leur dimensionnement est fonction de la taille de la poignée (1) et du refroidissement souhaité.

Le matériau constitutif des ailettes (11) est métallique et conducteur de chaleur. Préférentiellement ce matériau peut être de l'aluminium ou encore du cuivre.

Dans une variante, ce matériau peut être un caloduc.

Dans un second mode de réalisation de la poignée (1), le dissipateur (10) thermique, visible à la figure 4, est un radiateur (12). Ce radiateur (12) comprend au moins deux ailettes (13) montées verticalement pour obtenir un refroidissement par convection et les ailettes (13) sont parallèles entre elles.

Dans un troisième mode de réalisation de la poignée (1), le dissipateur (10) thermique, visible à la figure 5, est un dissipateur à chaleur latente. Par dissipateur à chaleur latente on entend que le dissipateur est fait dans un matériau qui change de phase lorsqu'il atteint une certaine température.

Conformément au troisième mode de réalisation de la poignée (1), celui-ci est composé d'un corps solide (14). Ce corps solide (14) comprend un point de fusion compris entre 50°C et 70°C. Ce corps solide (14) est un mélange à base de paraffine.

Dans ce troisième mode de réalisation, la poignée (1) peut comprendre en outre un diffuseur (16) thermique. Celui-ci peut être relié thermiquement à la pièce (9) de jonction ou directement à la seconde (8) surface de contact du générateur (3) thermoélectrique.

Le diffuseur (16) thermique s'étend longitudinalement dans la poignée (1) et plus particulièrement dans le corps solide (14).

Dans les trois modes de réalisation de la poignée (1) précédemment décrits, celle-ci peut également comprendre un dispositif électronique (17) relié au générateur (3) thermoélectrique. Ce dispositif électronique (17) peut être un afficheur (18) électronique ou un capteur électronique (19).

Ce capteur électronique (19) peut être par exemple et de façon non limitative un capteur de température.

Afin d'améliorer l'évacuation de la chaleur hors de la poignée (1) des premiers et seconds modes de réalisations énumérés ci dessus, on peut ajouter sur celle-ci des ouvertures débouchantes transversales (20) de ventilation comme visibles à la figure 1.

Le nombre de ces ouvertures débouchantes transversales (20) ainsi que le diamètre de celles-ci est adapté et proportionnel à la surface ou au volume du dissipateur (10) thermique.

Dans le cadre du premier mode de réalisation du dissipateur (10) thermique où celui-ci est composé de deux ailettes (11), les ouvertures débouchantes transversales (20) ont des ouvertures d'entrée E1 par lesquelles l'air est aspiré et des ouvertures de sortie E2 par lesquelles l'air est expulsé. La surface totale S2 représente la surface cumulée de toutes les ouvertures de sortie E2 par lesquelles l'air est expulsé et la surface totale S1 représente la surface cumulée de toutes les ouvertures d'entrée E1 par lesquelles l'air est aspiré. Afin de dimensionner le nombre et la taille de ces ouvertures pour que le rendement du générateur (3) thermoélectrique soit optimal, il faut que la surface totale S2 soit égale à trois fois la longueur L, qui représente la longueur totale des ailettes. Toujours dans l'optique de rendement maximal, la surface totale S1 doit être supérieure à la surface totale S2.

Le même raisonnement, sur la taille des ouvertures débouchantes transversales (20), s'applique au second mode de réalisation de la poignée (1).

Une autre solution, ou en complément de ces ouvertures débouchantes transversales (20), on peut également rajouter des ouvertures débouchantes longitudinales de ventilation non représentées. De la même manière que les ouvertures transversales (20), le nombre ainsi que le diamètre de ces ouvertures longitudinales est adapté à la surface ou au volume du dissipateur (10) thermique.

La poignée (1) dans son premier et second mode de réalisation, peut également comprendre un micro-ventilateur (22) relié au générateur (3) thermoélectrique afin d'être alimenté en courant.

Dans le cas du fonctionnement de la poignée (1) conforme au premier et deuxième mode de réalisation de la poignée (1), l'invention consiste tout d'abord à établir un couplage thermique performant et répétable entre le générateur (3) thermoélectrique et la paroi (27) du récipient (2) ou du couvercle. Ceci est obtenu par la pièce de couplage (6) en aluminium qui maximise la surface de contact avec la paroi (27) du récipient (2) ou du couvercle, et lorsque la poignée (1) est verrouillée sur le récipient (2) ou le couvercle par le dispositif (4) de verrouillage, cette pièce de couplage (6) est mise fortement en contrainte sur la portion (7) de la paroi (27) du récipient (2) ou du couvercle.

Lors de la mise en chauffe du récipient (2), la paroi (27) en aluminium de celui-ci va progressivement s'échauffer.

Dans le cas où la poignée (1) est conforme au premier mode de réalisation, c'est-à-dire lorsque le dissipateur (10) thermique est composé de deux ailettes (11) métalliques, un flux thermique va alors s'établir entre la paroi (27) et les ailettes (11). Ces dernières s'échauffant à leur tour, une convection naturelle de l'air ambiant va se produire à l'intérieur de la poignée (1) au niveau des ouvertures débouchantes transversales (20). Comme cela a été énoncé précédemment ces ouvertures débouchantes transversales (20) permettent d'améliorer le processus de convection au sein de la poignée (1). Cette convection peut être accélérée par des ouvertures débouchantes longitudinales de ventilation placées dans le sens longitudinal de la poignée (1).

Les ouvertures débouchantes transversales (20) et les ouvertures débouchantes longitudinales peuvent se cumuler ou on peut n'avoir que l'une ou l'autre de ces ouvertures.

Cette convection dans ces ouvertures peut aussi être accélérée par l'utilisation du micro-ventilateur (22) positionné sur la poignée (1).

Le but de cette convection est de permettre à la poignée (1), et plus particulièrement aux ailettes (11), de céder de la chaleur à l'air ambiant et ainsi d'établir un régime permanent entre la paroi (27) du récipient (2) ou du couvercle et l'air ambiant.

Le flux thermique qui va s'établir en régime permanent va ainsi traverser le module thermoélectrique par l'intermédiaire de la pièce de couplage (6) et créer à ses bornes une tension électrique qui sera proportionnelle au flux thermique.

Ainsi, si le flux thermique est nul, la tension électrique sera nulle, ce qui arrive quand les ailettes (11) n'évacuent pas suffisamment de chaleur.

Dans le cas où le récipient (2) est placé sur un foyer dissipant une puissance de 300 W, le flux obtenu en régime permanent au travers du module thermoélectrique va de 3 W/cm² à 6 W/cm², ce qui correspond à une production électrique allant de 7,2 mW à 14 mW sous une plage de tension allant de 1,5 V à 2,7 V.

Préférentiellement le flux moyen obtenu en régime permanent au travers du module thermoélectrique est d'environ 3 W/cm², ce qui conduit à une production électrique de 7,2 mW sous une tension de 1,5 V.

Lorsque la poignée (1) comprend un dispositif électronique (17) relié au générateur (3) thermoélectrique, comme par exemple un afficheur (18) électronique, un capteur électronique (19), ou un micro ventilateur (22), une telle production électrique est suffisante pour alimenter en énergie ces différents dispositifs électroniques (17).

Dans le cas maintenant où la poignée (1) est conforme au second mode de réalisation, c'est-à-dire lorsqu'il est composé d'un radiateur (12) avec au moins deux ailettes (13) montées verticalement pour obtenir un refroidissement par convection, le fonctionnement est identique au cas du premier mode de réalisation de la poignée (1) où le dissipateur (10) thermique est composé de deux ailettes (11) longitudinales.

Dans le cas maintenant où la poignée (1) est conforme au troisième mode de réalisation, c'est-à-dire lorsqu'il est composé d'un dissipateur à chaleur latente composé d'un corps solide (14) dont le point de fusion est compris entre 50°C et 70°C, c'est ce corps solide (14) qui est utilisé comme source froide du générateur (3) thermoélectrique et plus particulièrement l'énergie latente de changement de phase de ce corps solide (14) lorsque celui-ci va progressivement fondre. Puis ce corps solide (14), une fois fondu, devra à son tour céder cette énergie latente à l'environnement lors d'une période de non utilisation du produit, ce qui ne pose pas de problème vu les cycles d'usage des produits domestiques. Le corps solide (14), qui en l'espèce est de la paraffine, va progressivement reprendre son état solide une fois mis à l'écart de la source de chauffe.

Dans le cas où la poignée (1) comprend en outre un diffuseur (16) thermique, celui-ci permet de diffuser la chaleur d'un côté à l'autre de la poignée (1).

Dans ce troisième mode de réalisation, la poignée (1) peut également comprendre les ouvertures débouchantes (20) transversales et/ou les ouvertures débouchantes longitudinales mentionnées précédemment afin d'accélérer le refroidissement.

Ce troisième mode de réalisation fonctionne précisément de la manière suivante : lors de la chauffe du récipient (2), un flux s'établit au travers du générateur (3) thermoélectrique, allant de la source chaude (la paroi (27) du récipient (2)) vers la source froide constituée du corps solide (14) et éventuellement du diffuseur (16) thermique. Dans un premier temps, la température du corps solide (14) va progressivement s'élever de la température ambiante jusqu'à sa température de fusion (environ 50°C). Ensuite, le corps solide (14) va progressivement fondre, en restant à une température d'environ 50°C, permettant ainsi au flux thermique au travers du générateur (3) thermoélectrique de rester constant, et il en va de même pour la production électrique. Pendant cette période, la température de la poignée (1) reste relativement froide par rapport à une poignée classique. Au bout d'un temps, qui dépend de la quantité de corps solide (14) et de la puissance du foyer, le corps solide (14) sera complètement fondu, et la température de la poignée (1) recommencera à s'élever jusqu'à trouver un équilibre thermique avec l'air environnant. Dans un cas standard où le récipient (2) est placé sur un foyer dissipant 300W, une poignée (1) contenant 40 cm3 de corps solide (14) type paraffine, permet un fonctionnement stable du générateur (3) thermoélectrique pendant 85 minutes, la puissance maximale récupérable étant de 20mW sous 2,5V, alors que la température extérieure de la poignée (1) reste à 66°C.

Au moins la pièce de couplage (6), le générateur (3) thermoélectrique ainsi que le dissipateur (10) thermique forment un dispositif de génération d'électricité qui peut être mobile de la poignée (1) afin de procéder à un nettoyage ou à un changement de pièces défectueuses. Ce dispositif de génération d'électricité peut être fixé à l'intérieur de la poignée (1) par des clips, par aimantation ou encore par des glissières à l'intérieur de la poignée (1).

On comprendra que diverses modifications et/ou améliorations évidentes pour l'homme du métier peuvent être apportées aux modes de réalisation de l'invention décrits dans la présente description sans sortir du cadre de l'invention défini par les revendications annexées.

## Revendications

1. Poignée (1) pour récipient (2) de cuisson ou pour couvercle de récipient de cuisson qui comprend au moins un générateur (3) thermoélectrique ladite poignée (1) comprenant un dispositif (4) de verrouillage libérable ladite poignée étant **caractérisée en ce que** le générateur (3) thermoélectrique comprend au moins une première (5) surface de contact reliée thermiquement à une pièce de couplage (6) thermique qui vient en contact sous contrainte avec une portion (7) du récipient (2) de cuisson ou du couvercle lorsque le dispositif (4) de verrouillage libérable de la poignée (1) est dans une position verrouillée sur le récipient (2) de cuisson ou le couvercle.

2. Poignée (1) pour récipient (2) de cuisson ou pour couvercle de récipient de cuisson selon la revendication 1 **caractérisée en ce que** le générateur (3) thermoélectrique comprend une seconde (8) surface de contact reliée thermiquement à une pièce (9) de jonction.

3. Poignée (1) pour récipient (2) de cuisson ou pour couvercle de récipient de cuisson selon l'une des revendications 1 ou 2 **caractérisée en ce que** la poignée (1) comprend un dissipateur (10) thermique relié thermiquement à la pièce (9) de jonction ou directement à une seconde (8) surface de contact du générateur (3) thermoélectrique.

4. Poignée (1) pour récipient (2) de cuisson ou pour couvercle de récipient de cuisson selon la revendication précédente **caractérisée en ce que** le dissipateur (10) thermique est composé d'une ou plusieurs ailettes (11) de longueur inférieure à la poignée (1).

5. Poignée (1) pour récipient (2) de cuisson ou pour couvercle de récipient de cuisson selon la revendication précédente **caractérisée en ce que** les ailettes (11) sont réalisées dans un matériau conducteur de chaleur.

6. Poignée (1) pour récipient (2) de cuisson ou pour couvercle de récipient de cuisson selon la revendication 4 **caractérisée en ce que** les ailettes (11) sont des caloducs.

7. Poignée (1) pour récipient (2) de cuisson ou pour couvercle de récipient de cuisson selon la revendication 3 **caractérisée en ce que** le dissipateur (10) thermique est composé d'un radiateur (12) comprenant au moins deux ailettes (13) montées verticalement et parallèlement pour obtenir un refroidissement par convection.

8. Poignée (1) pour récipient (2) de cuisson ou pour couvercle de récipient de cuisson selon la revendication 3 **caractérisée en ce que** le dissipateur (10) thermique est un dissipateur à chaleur latente composé d'un corps solide (14) qui comprend un point de fusion compris entre 50°C et 70°C.

9. Poignée (1) pour récipient (2) de cuisson ou pour couvercle pour récipient de cuisson selon la revendication 8 **caractérisée en ce que** la poignée (1) comprend un diffuseur (16) thermique.

10. Poignée (1) pour récipient (2) de cuisson ou pour couvercle de récipient de cuisson selon l'une des revendications précédentes **caractérisée en ce que** la poignée (1) comprend un dispositif électronique (17) relié au générateur (3) thermoélectrique.

11. Poignée (1) pour récipient (2) de cuisson ou pour couvercle pour récipient de cuisson selon la revendication précédente **caractérisée en ce que** le dispositif électronique (17) peut être un afficheur (18) électronique ou un capteur électronique (19).

12. Poignée (1) pour récipient (2) de cuisson ou pour couvercle de récipient de cuisson selon l'une des revendications précédentes **caractérisée en ce que** la poignée (1) comprend des ouvertures débouchantes transversales (20) et/ou des ouvertures débouchantes longitudinales de ventilation.

13. Poignée (1) pour récipient (2) de cuisson ou pour couvercle de récipient de cuisson selon l'une des revendications précédentes **caractérisée en ce que** la poignée (1) comprend un micro-ventilateur (22) relié au générateur (3) thermoélectrique.

## Patentansprüche

1. Handgriff (1) für Kochbehälter (2) oder für Kochbehälterdeckel, der mindestens einen thermoelektrischen Generator (3) umfasst, wobei der Handgriff (1) eine lösbare Verriegelungsvorrichtung (4) umfasst, wobei der Handgriff **dadurch gekennzeichnet ist, dass** der thermoelektrische Generator (3) mindestens eine erste (5) Kontaktoberfläche umfasst, thermisch mit einem thermischen Kupplungsstück (6) verbunden, das unter Belastung mit einem Teil (7) des Kochbehälters (2) oder des Deckels in Kontakt kommt, wenn die lösbare Verriegelungsvorrichtung (4) des Handgriffs (1) in einer verriegelten Position an dem Kochbehälter (2) oder dem Deckel vorliegt.

2. Handgriff (1) für Kochbehälter (2) oder für Kochbehälterdeckel nach Anspruch 1, **dadurch gekennzeichnet, dass** der thermoelektrische Generator (3) eine zweite (8) Kontaktoberfläche, thermisch mit einem Verbindungsstellenstück (9) verbunden, umfasst.

3. Handgriff (1) für Kochbehälter (2) oder für Kochbehälterdeckel nach einem der Ansprüche 1 oder 2, **dadurch gekennzeichnet, dass** der Handgriff (1) einen thermischen Kühlkörper (10), thermisch mit dem Verbindungsstellenstück (9) oder direkt mit einer zweiten (8) Kontaktoberfläche des thermoelektrischen Generators (3) verbunden, umfasst.

4. Handgriff (1) für Kochbehälter (2) oder für Kochbehälterdeckel nach dem vorstehenden Anspruch, **dadurch gekennzeichnet, dass** der thermische Kühlkörper (10) aus einer oder mehreren Rippen (11) von kürzerer Länge als der Handgriff (1) aufgebaut ist.

5. Handgriff (1) für Kochbehälter (2) oder für Kochbehälterdeckel nach dem vorstehenden Anspruch, **dadurch gekennzeichnet, dass** die Rippen (11) aus einem wärmeleitenden Material hergestellt sind.

6. Handgriff (1) für Kochbehälter (2) oder für Kochbehälterdeckel nach Anspruch 4, **dadurch gekennzeichnet, dass** die Rippen (11) Wärmeleitrohre sind.

7. Handgriff (1) für Kochbehälter (2) oder für Kochbehälterdeckel nach Anspruch 3, **dadurch gekennzeichnet, dass** der thermische Kühlkörper (10) aus einem Radiator (12) aufgebaut ist, der mindestens zwei Rippen (13) umfasst, die vertikal und parallel montiert sind, um eine Kühlung durch Konvektion zu erzielen.

8. Handgriff (1) für Kochbehälter (2) oder für Kochbehälterdeckel nach Anspruch 3, **dadurch gekennzeichnet, dass** der thermische Kühlkörper (10) ein Kühlkörper für latente Wärme ist, aufgebaut aus einem festen Körper (14), der einen Schmelzpunkt im Bereich zwischen 50 °C und 70 °C umfasst.

9. Handgriff (1) für Kochbehälter (2) oder für Kochbehälterdeckel nach Anspruch 8, **dadurch gekennzeichnet, dass** der Handgriff (1) einen thermischen Diffusor (16) umfasst.

10. Handgriff (1) für Kochbehälter (2) oder für Kochbehälterdeckel nach einem der vorstehenden Ansprüche, **dadurch gekennzeichnet, dass** der Handgriff (1) eine elektronische Vorrichtung (17), mit dem thermoelektrischen Generator (3) verbunden, umfasst.

11. Handgriff (1) für Kochbehälter (2) oder für Kochbehälterdeckel nach dem vorstehenden Anspruch, **dadurch gekennzeichnet, dass** die elektronische Vorrichtung (17) ein elektronisches Anzeigegerät (18) oder ein elektronischer Sensor (19) sein kann.

12. Handgriff (1) für Kochbehälter (2) oder für Kochbehälterdeckel nach einem der vorstehenden Ansprüche, **dadurch gekennzeichnet, dass** der Handgriff (1) querverlaufende Durchgangsöffnungen (20) und/oder längsverlaufende Durchgangsöffnungen zur Belüftung umfasst.

13. Handgriff (1) für Kochbehälter (2) oder für Kochbehälterdeckel nach einem der vorstehenden Ansprüche, **dadurch gekennzeichnet, dass** der Handgriff (1) einen Mikroventilator (22), mit dem thermoelektrischen Generator (3) verbunden, umfasst.

## Claims

1. Handle (1) for cooking vessel (2) or cooking vessel lid, which comprises at least one thermoelectric generator (3), wherein said handle (1) comprises a releasable locking device (4), said handle being **characterised in that** the thermoelectric generator (3) comprises at least one first contact surface (5) connected thermally to a thermal coupler (6) which comes into contact under pressure with a section (7) of the cooking vessel (2) or lid when the releasable locking device (4) of the handle (1) is in a locked position on the cooking vessel (2) or lid.

2. Handle (1) for cooking vessel (2) or for cooking vessel lid according to claim 1, **characterised in that** the thermoelectric generator (3) comprises a second contact surface (8) connected thermally to a connection part (9).

3. Handle (1) for cooking vessel (2) or for cooking vessel lid according to one of claims 1 or 2, **characterised in that** the handle (1) comprises a heat sink (10) connected thermally to the connection part (9) or directly to a second contact surface (8) of the thermoelectric generator (3).

4. Handle (1) for cooking vessel (2) or for cooking vessel lid according to the preceding claim, **characterised in that** the heat sink (10) is comprised of one or more fins (11) of length less than the handle (1).

5. Handle (1) for cooking vessel (2) or for cooking vessel lid according to the preceding claim, **characterised in that** the fins (11) are made of a heat-conductive material.

6. Handle (1) for cooking vessel (2) for cooking vessel lid according to claim 4, **characterised in that** the fins (11) are heat pipes.

7. Handle (1) for cooking vessel (2) or for cooking vessel lid according to claim 3, **characterised in that** the heat sink (10) is comprised of a radiator (12) comprises at least two fins (13) assembled vertically and parallel to one another, to obtain convection cooling.

8. Handle (1) for cooking vessel (2) or for cooking vessel lid according to claim 3, **characterised in that** the heat sink (10) is a latent heat sink comprised of a solid body (14) with a melting point of between 50°C and 70°C.

9. Handle (1) for cooking vessel (2) or for cooking vessel lid according to claim 8, **characterised in that** the handle (1) comprises a heat diffuser (16).

10. Handle (1) for cooking vessel (2) or for cooking vessel lid according to one of the preceding claims, **characterised in that** the handle (1) comprises an electronic device (17) connected to the thermoelectric generator (3).

11. Handle (1) for cooking vessel (2) or for cooking vessel lid according to the preceding claim, **characterised in that** the electronic device (17) can be an electronic display (18) or an electronic sensor (19).

12. Handle (1) for cooking vessel (2) or for cooking vessel lid according to one of the preceding claims, **characterised in that** the handle (1) comprises transversal open-ended openings (20) and/or longitudinal ventilation open-ended openings.

13. Handle (1) for cooking vessel (2) or for cooking vessel lid according to one of the preceding claims, **characterised in that** the handle (1) comprises a micro-fan (22) connected to the thermoelectric generator (3).
